# EUROPEAN PATENT SPECIFICATION

(11) **EP 0 780 028 B1**
(45) Date of publication and mention of the grant of the patent: **15.04.1998**
(21) Application number: 95926729.5
(22) Date of filing: 19.07.1995
(51) Int. Cl.: H01R 9/09, H01L 23/485, H05K 3/34

(54) **BALL GRID ARRAY SOCKET**
KUGELRASTERBUCHSEGEHAÜSE
DOUILLE A AGENCEMENT EN GRILLE POUR BILLES

(30) Priority: 06.09.1994 US 301368
(43) Date of publication of application: 25.06.1997
(73) Proprietor: THE WHITAKER CORPORATION, Wilmington, Delaware 19808 (US)
(72) Inventor: GRABBE, Dimitry, G., Middletown, PA 17057 (US); MILBRAND, Donald, Wayne, Mechanicsburg, PA 17055 (US); RINGLER, Daniel, Robert, Elizabethville, PA 17023 (US)
(74) Representative: Heinz-Schäfer, Marion
(86) International application number: PCT/US95/09031
(87) International publication number: WO 96/08056

(56) References cited:
- US-A- 3 303 393
- US-A- 5 137 456
- US-A- 5 329 423

## Description

The invention is directed to solder ball contact assembly. In particular, the invention is directed to a socket which cooperates with the solder balls to allow for the mating and unmating of a ceramic substrate or the like from a printed circuit board or the like over many cycles.

As the complexity of integrated circuit packages continues to increase, it becomes more difficult to adequately position the leads around the perimeter of the integrated circuit package without increasing the overall size of the integrated circuit package. Although packages with leads spaced on centers as fine as 0.3 millimeters (0.012 inches) are currently being marketed, the benefits of the resulting increase in packaging efficiency are offset by decreased assembly yields and increased assembly process complexity, both adding to system cost. Therefor, in order to increase the number of leads while maintaining the size of the integrated circuit package, it has become necessary to have packages with high numbers of connections arranged in a rectangular grid, or array, on the surface of the package. One such solution is shown in the article entitled "Attachment of Solder Ball Connect (SBC) Packages to Circuit Boards" published in IBM Journal of Research and Development, Volume 37 Number 5, dated September 19, 1993.

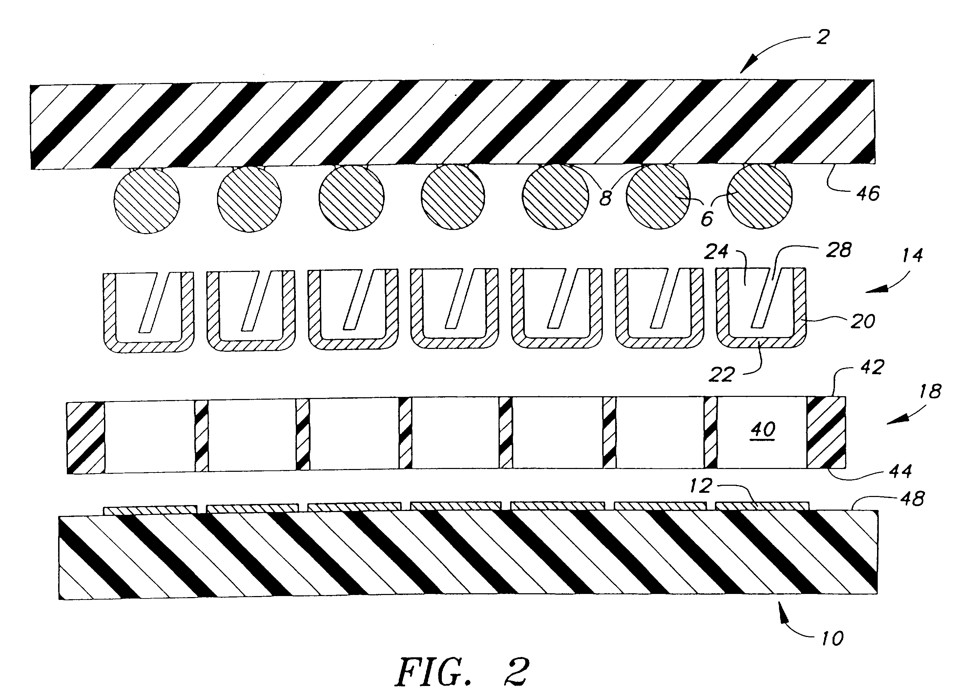

Although the technology shown in the above referenced article provides solutions to density and size, it does not allow for the removal of the ceramic substrate from the card. As shown in figure 2, page 598, the ceramic substrate and card are joined to the solder balls by eutectic soldered joints. As the solder balls are joined to both the substrate and the card by way of soldered joints, this is a permanent connection is established and it is therefor difficult to repair and replace the substrate of a problem occurs. As the electrical connection between the substrate and board requires solder, testing of the substrate prior to installation is difficult and expensive. It would therefore be advantageous, to provide an interconnection between the ceramic substrate and the board which allows for numerous cycles of mating and unmating to facilitate testing and repair thereof. U.S. Patent No. 5,329,423 discloses a socket provide on a substrate. However, this socket does not include any contact retention means.

The invention is directed to a device which provides a "pin and socket" type connection between a first substrate and a second substrate. The socket is for mating with a mating contact having an arcuate surface. The socket has a bottom wall and a side wall which extends from the bottom wall in a direction essentially perpendicular to the bottom wall. The side wall forms an opening into which the mating contact is inserted. Contact retention points are provided on the side wall and extend into the opening. The contact retention points cooperate with the mating contact to provide the electrical connection between the mating contact and the socket.

The invention is also directed to a socket assembly having the socket described above in combination with the arcuate mating contact whereby as the first substrate and the second substrate are mated together, the arcuate mating contact will be received in the opening of the socket and retained therein by the contact retention points.

The invention is also directed to a substrate mating assembly with a first substrate with at least one socket mounted thereon. The at least one socket has contact retention points provided thereon which extend into a contact receiving opening thereof. A second substrate is provided with at least one mating contact mounted thereon. The at least one mating contact has an arcuate surface and is dimensioned to be received in the contact receiving opening of the at least one socket. As the first substrate and the second substrate are electrically mated together, the at least one mating contact is received in the contact receiving opening and maintained in position therein by the cooperation of the contact retention points with the arcuate surface of the at least one mating contact. The contact retention points are provided on resilient arms which are configured to allow for the elastic distortion thereof as the at least one mating contact is brought into engagement with the at least one socket, such that when the at least one mating contact is fully inserted, the resilient arms will return toward an unstressed position to cooperate with the surface of the at least one mating contact to maintain the at least one mating contact in position.

The invention will now be described by way of example with reference to the accompanying drawings in which:

FIGURE 1 is an exploded perspective view showing a ceramic substrate and a printed circuit board prior to socket receptacles being soldered thereto.

FIGURE 2 is a cross sectional view taken along line 2-2 of Figure 1.

FIGURE 3 is a cross sectional view, similar to Figure 2, showing the ceramic substrate mated to the printed circuit board.

FIGURE 4 is an enlarged cross sectional view of a respective socket receptacle, shown in Figure 3, with a solder ball positioned therein.

FIGURE 5 is a cross sectional view taken along line 5-5 of Figure 4 showing resilient arms of the socket receptacle in engagement with the solder ball.

FIGURE 6 is a cross sectional view, similar to that of Figure 5, showing the resilient arms with no solder ball positioned in the socket receptacle.

FIGURE 7 is a cross sectional view, similar to that of Figure 4, of a first alternate socket receptacle with a solder ball positioned therein.

FIGURE 8 is a cross sectional view, taken along line 8-8 of Figure 7, showing the resilient arms of the first alternate socket receptacle in engagement with the solder ball.

FIGURE 9 is a cross sectional view, similar to that of Figure 4, of a second alternate socket receptacle with a solder ball positioned therein.

FIGURE 10 is a cross sectional view, taken along line 10-10 of Figure 9, showing the resilient arms of the second alternate socket receptacle in engagement with the solder ball.

FIGURE 11 is a cross sectional view, similar to that of Figure 4, of a third alternate socket receptacle with a solder ball positioned therein.

FIGURE 12 is a cross sectional view, taken along line 12-12 of Figure 11, showing the resilient arms of the third alternate socket receptacle in engagement with the solder ball.

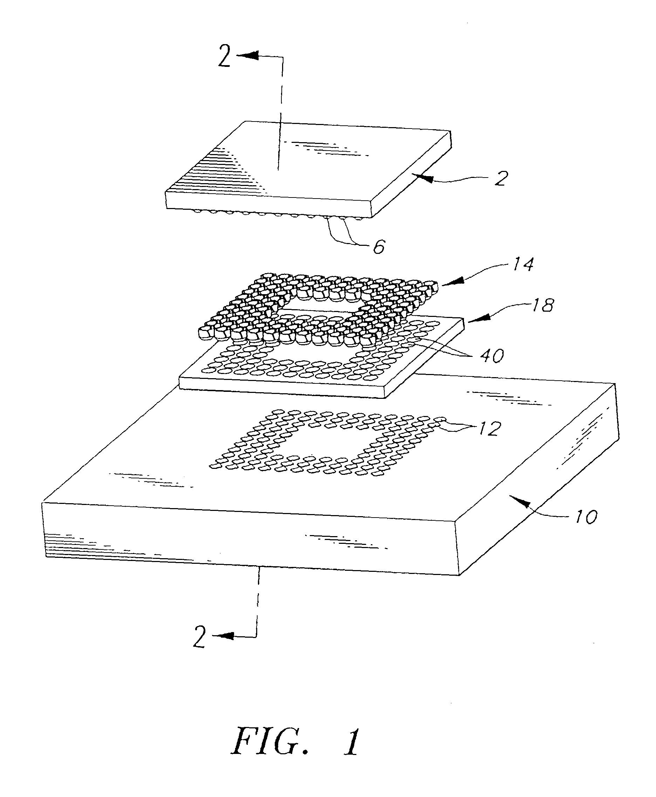

As shown in Figure 1, a substrate 2, made from ceramic or other material, has a plurality of solder balls 6 mounted to circuit pads 4 provided on a surface thereof. The solder balls 6 are maintained in position on the circuit pads 4 by means of solder 8. Although the balls 6 shown are referred to as solder balls, it is worth noting that the balls can be made of any conductive material which has the particular characteristics required for the particular application. The balls may be cylindrical in configuration or may have some other type of arcuate shape.

As will be further discussed, the ceramic substrate 2 is placed in electrical engagement with a printed circuit board 10 having copper traces or pads 12 provided thereon. As shown in Figure 2, socket receptacles 14 are positioned on the copper traces 12. The socket receptacles 14 are maintained on the copper traces 12 by means of solder 16. A plastic carrier/spacer 18 is provided proximate socket receptacles 14. In some applications, the plastic carrier may be removed after soldering.

In the instances where the solder balls are used, the socket receptacles 14 are made from a laminate material, wherein the inside of the receptacle will be of stainless steel or similar material, the core will be of copper or the like, and the outside surface, which is soldered to the circuit board, will be of tin or lead/tin. When balls made from other metals are used, the sockets can be made from such materials as copper alloys with nickel and gold overplate or gold overplate.

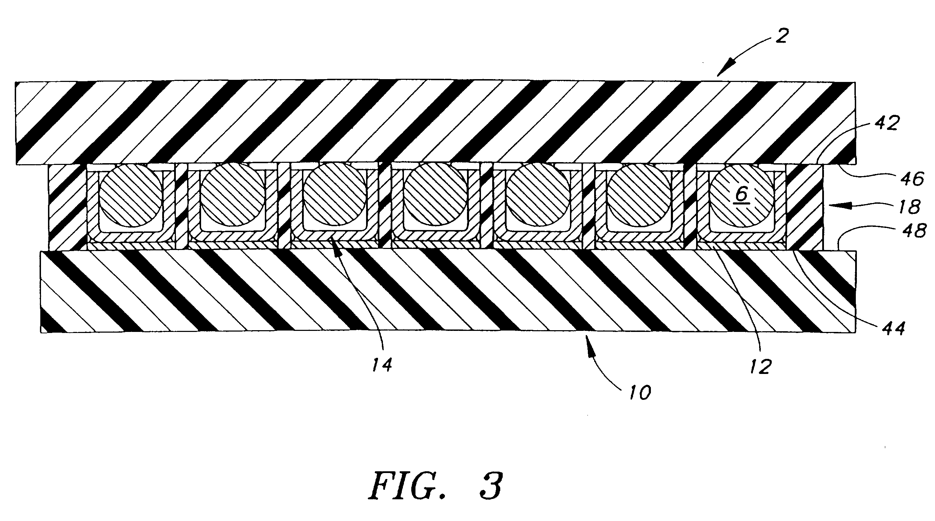

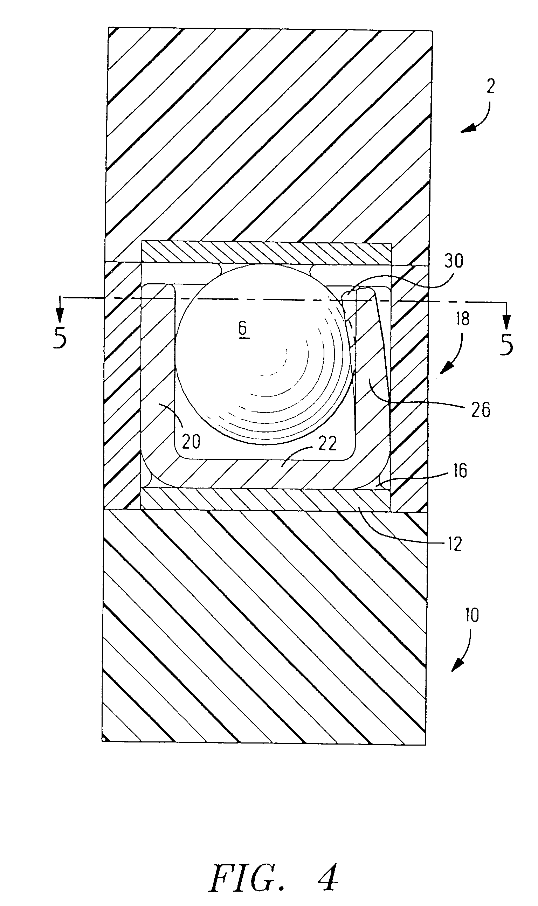

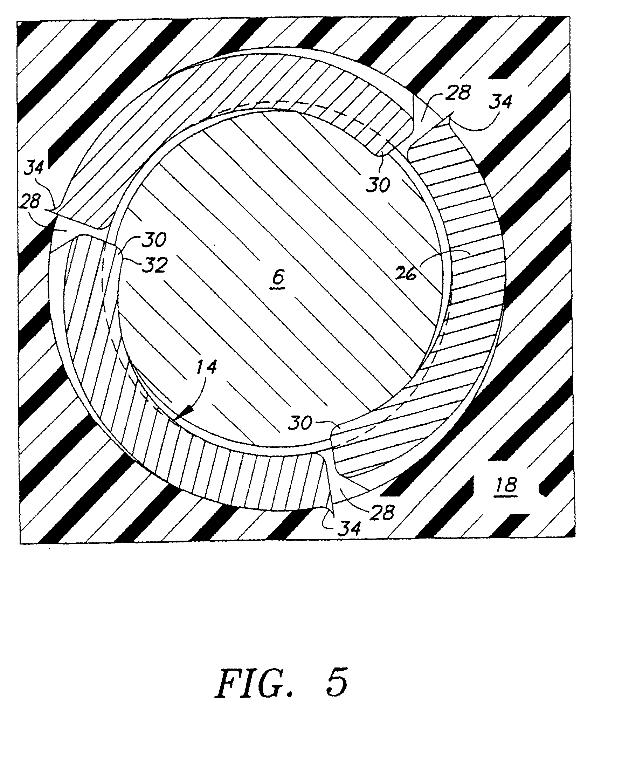

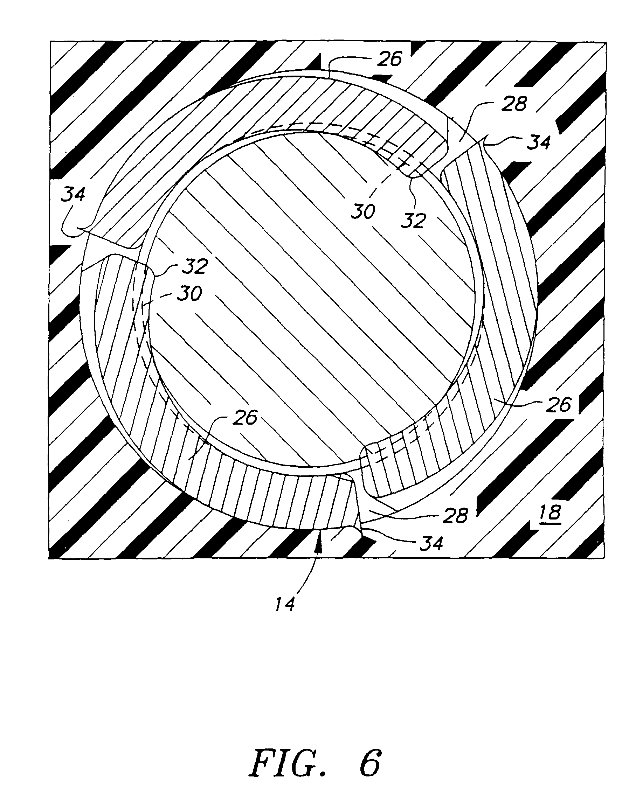

As is shown in Figures 1 through 6, each socket receptacle 14 has a bottom wall 22 and side wall 20. The side wall extends essentially perpendicular to the bottom wall 22 to form a solder ball receiving opening 24. Referring to Figure 4 and 5, the side wall 20 has resilient arms 26 provided therein. In the configuration shown, three resilient arms 26 are provided on each socket receptacle 14. The resilient arms 26 are spaced from each other by slots 28. Each resilient arm 26 has a solder ball retention point 30 provided at one end thereof and a plastic carrier retention barb 34 provided at the other end. The contact area 32 is positioned proximate the solder ball retention point 30. Various other configurations of the socket receptacle (several of which are shown in Figures 6 through 11) may be used to accomplish the object of the invention.

In order to properly position the socket receptacles 14 on the copper traces 12, the socket receptacles 14 must be maintained in proper position prior to soldering. The plastic carrier 18 performs this function. The individual socket receptacles 14 are loaded into the socket receptacle receiving openings 40 of the plastic carrier 18. The openings 40 are cylindrical in configuration, with the diameter of each opening dimensioned to be slightly larger than the diameter of the socket receptacles 14. The plastic carrier retention barbs 34 of the socket receptacles 14 dig into the sides of openings 40 to provide an interference fit which maintains the socket receptacles 14 in the plastic carrier 18. The sides of the openings 40 of the plastic carrier surround the side walls 20 of the socket receptacles 14, such that the sides of the openings are proximate the side walls. This dimensioning allows the sides of the opening to act as an overstress for the resilient arms 26. The positioning of the sides of the openings prevents the resilient arms from bulging outwardly away from the receiving opening 24, thereby preventing the resilient arms from taking a permanent set.

With the socket receptacles properly loaded in the plastic carrier 18, the carrier is moved into position relative to the circuit board 10. With the receptacles aligned with the traces, the receptacles are soldered to the traces.

The substrate 2 with the solder balls 6 soldered thereto is moved into alignment with the printed circuit board 10 with the socket receptacles 14 soldered thereto. The plastic carrier 18 is retained on the assembled printed circuit board 10 due to the cooperation of the barbs 34 with the carrier 18, as was previously discussed.

The substrate 2 and the printed circuit board 10 are then moved toward each other, causing the solder balls 6 to move into respective solder ball receiving openings 24 of the socket receptacles 14. As the solder balls 6 are moved into the openings 24, the solder balls 6 engage the solder ball retention points 30 of the socket receptacles 14. As the mating continues, the solder balls 6 will resiliently deform the arms 26 outwardly. The arms are configured to allow for the resilient distortion thereof, however, the distortion occurs in the elastic range so that the arms attempt to return to their original unstressed position.

As the resilient arms 26 are moved outwardly, the arms 26 exert forces on the solder balls 6. This force is sufficient for the solder ball retention points 30 to scrape the surfaces of the balls, thereby causing the solder ball retention points 30 to penetrate any oxides or the like which is present on the surface of the solder balls 6 and ensuring that a positive electrical connection is provided between the solder balls 6 and the contact areas 32 of the arms 26.

The mating of the substrate 2 and the circuit board 10 continues until the top surface 42 of the plastic carrier 18 engages the bottom surface 46 of the substrate 2 and the bottom surface 44 of the plastic carrier 18 engages the top surface 48 of the printed circuit board 10. In this position, the substrate 2 and the printed circuit board 10 are spaced from each other and cannot move closer to each other. The assembly is maintained in this position due to the cooperation of the solder ball 6 with the resilient arms 26 of the socket receptacles 14. As best shown in Figure 4, the resilient arms 26 return toward the unstressed position to a new stressed position when the solder balls are fully inserted. In this position, the resilient arms 26 cooperate with the curvature of the solder balls 6 to exert a downward force on the solder balls to ensure that the solder balls are maintained in position. This force is sufficient to maintain the substrate in the fully mated position relative to the printed circuit board, thereby ensuring that a proper electrical connection is provided therebetween.

The use of the plastic carrier or spacer 18 ensures that the solder ball 6 will not engage the bottom wall 22 of the socket receptacle 14. This prevents the solder ball from being damaged by the bottom wall 22. If the ball is made from another material, the use of the plastic carrier as a spacer may not be required, as it is not necessary to prevent the ball from contacting the bottom wall of the socket. In fact, in instances in which the balls are made from material other than solder, it may be advantageous for the ball to contact the bottom wall to provide another current path.

The use of the solder ball and socket receptacle allow the ceramic substrate to be removably mounted to the printed circuit board. This "pin and socket" type termination allows for the substrate to be removed from the printed circuit board as is needed. The removability allows for such things as burn in type testing, repair and replacement, and other similar options. As the socket balls are removable, it is important to make the receptacles of a material with does not have an affinity for tin on the surfaces which engage the solder balls. If a small amount of tin is transferred to the inside surface of the socket receptacles and the socket balls are unplugged or removed, the thin film of tin will convert to a tin oxide, which is a high resistance or even an insulator material, thereby reducing the possibility of making a proper electrical connection during future matings.

The use of sockets also permits for the lateral displacement of the ball induced by the expansion of the package by power cycling to yield elastically and the arms will follow the ball's trajectory of expansion and contraction.

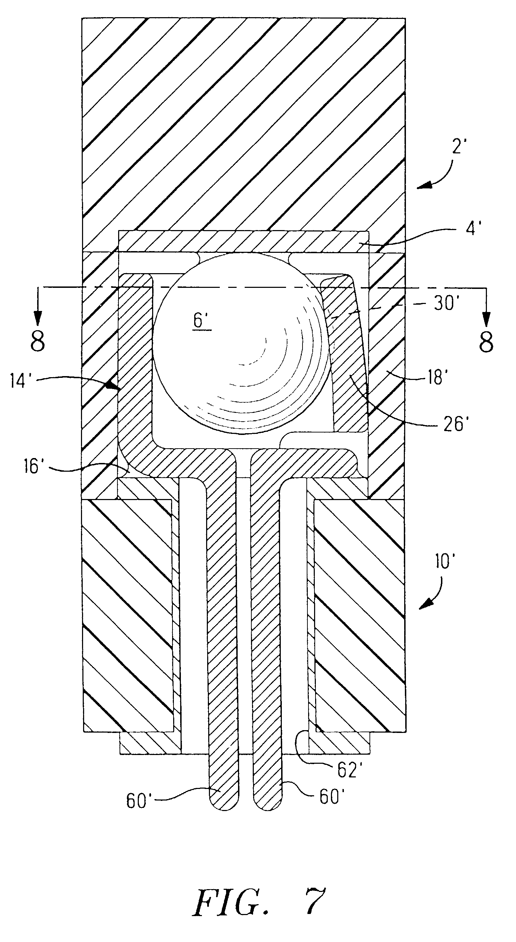

Figures 7 through 12 illustrate alternative embodiments of the socket receptacle 14. These embodiments operate in a similar manner to that described above, however, the retention points are slightly different. For ease of explanation and understanding, the same references numbers as above with the appropriate number of prime marks will be used.

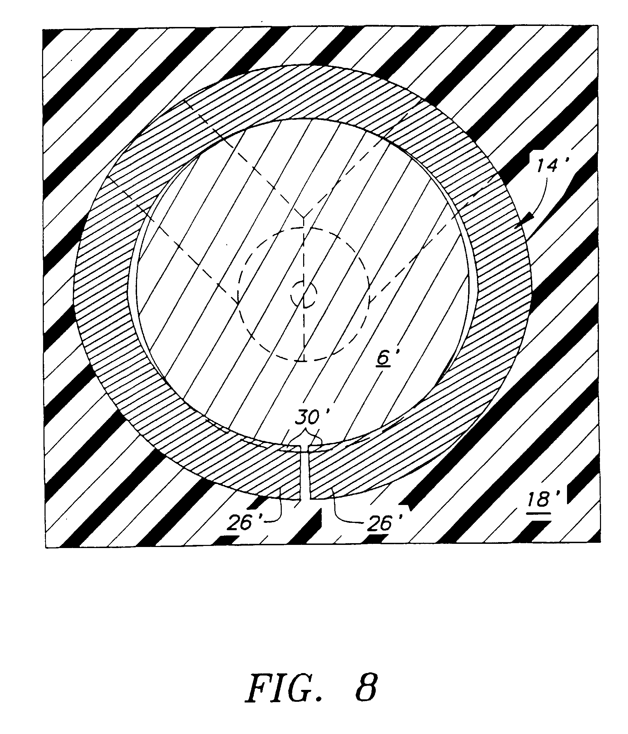

The socket receptacle shown in Figures 7 and 8 is stamped and formed from flat stock. The resilient arms 26' cooperate with the solder ball 6' as was previously discussed. As best shown in Figure 7, socket receptacle 14' has legs 60' which extend into through holes 62' of printed circuit board 10'. The legs 60' are soldered in place in the conventional manner. The socket 14' in this configuration is held in place on the plastic spacer 18' by means of a frictional engagement therebetween.

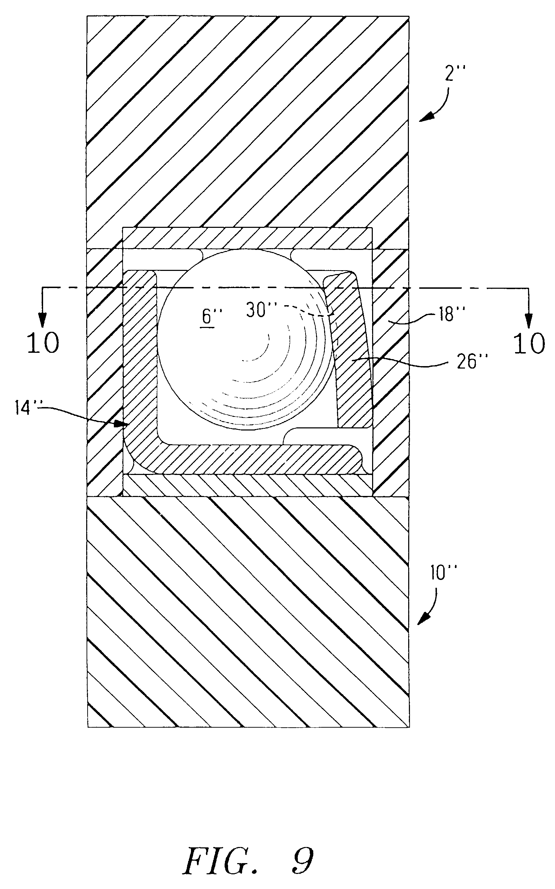

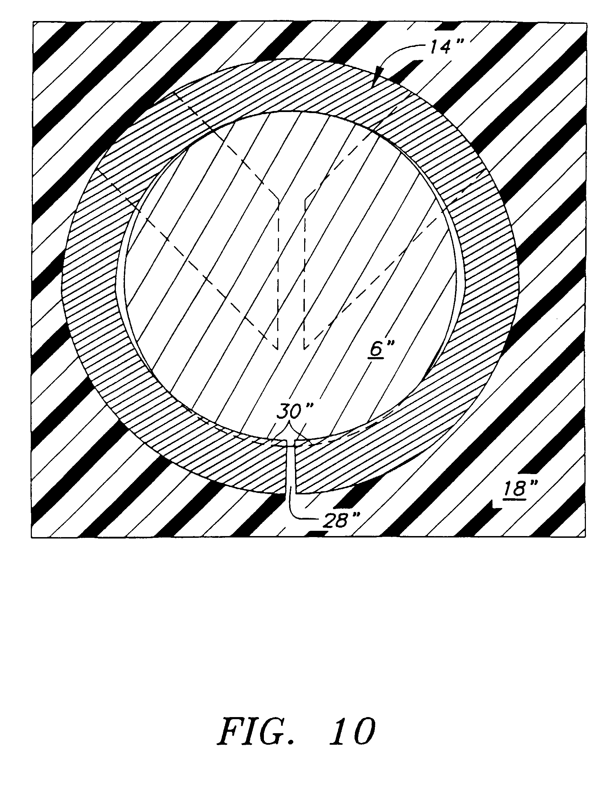

Figures 9 and 10 illustrate a receptacle socket 26" in which the upper portion is identical to socket 26'. However, receptacle socket 26" is surface mounted to printed circuit board 10".

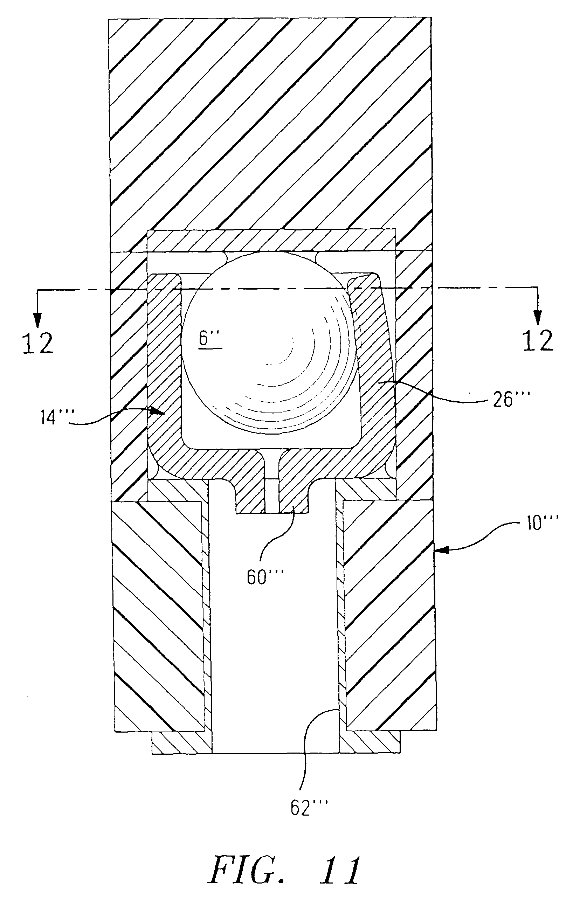

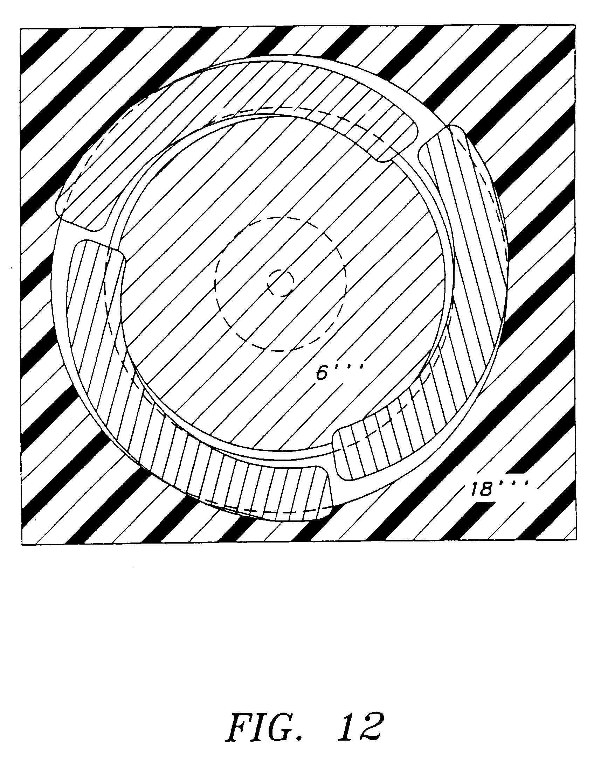

Figure 11 and 12 are directed to a drawn socket 26"' in which the bottom is pierced to provide a positioning member 60"' which helps to center the socket in the through hole 62"' of the printed circuit board 10"'.

The invention illustrated by the embodiments is important because, as the complexity of the circuit boards increase, the number of power and ground interconnections also increases. Thus, the need for packages accommodating a thousand or more interconnections, even for a single chip, is rapidly becoming a reality. The use of the balls meets these requirements. The balls are easily located accurately with an aperture plate and require no orientational positioning, thereby providing an inherently low cost process. Whether these balls are made from solder, or any other material, these benefits prevail.

The solder balls described above are advantageous for small packages. However, for larger packages, hard balls utilizing spring tempered metal can be used. The metal can be plated with various substances such as gold or gold over nickel.

The socketing of the balls is advantageous as it allows for sufficient compliance to accommodate power cycling induced displacement without overstressing the solder connections. The material used in the socket and ball allow the electromagnetic properties of the socket to be indistinguishable from the balls alone.

Changes in construction will occur to those skilled in the art and various apparently different modifications and embodiments may be made without departing from the scope of the invention. The matter set forth in the foregoing description and accompanying drawings is offered by way of illustration only. It is therefor intended that the foregoing description be regarded as illustrative rather than limiting.

## Claims

1. A socket assembly having a socket (14) provided on a first substrate (10) and an arcuate mating contact provided on a second substrate (2), the socket assembly characterized in that:
the socket (14) has contact retention points (30) extending from a side wall (20) thereof, the contact retention points (30) extend into an opening defined by the sidewall (20), the opening is dimensioned to receive the arcuate mating contact (6) therein; whereby as the first substrate (10) and the second substrate (2) are mated together, the arcuate mating contact (6) will be received in the opening of the socket (14) and retained therein by the contact retention points (30).

2. A socket assembly as recited in claim 1 further characterized in that the arcuate mating contact (6) is a conductive ball.

3. A socket assembly as recited in claim 1 or 2 further characterized in that the mating contact (6) is surface mounted to the second substrate (2) and the socket (14) is surface mounted to the first substrate (10).

4. A socket assembly as recited in any of claims 1-3 further characterized in that the socket (14) is a laminate material, the inside layer of the laminate material is a material which does not have an affinity for tin.

5. A socket assembly as recited in any of claims 1-4 further characterized in that the laminate has an inside surface of stainless steel.

6. A socket assembly as recited in any of claims 1-5 further characterized in that the socket (14) is a spring temper metal.

7. A socket assembly as recited in any of claims 1-6 further characterized in that the contact retention points (30) are provided on resilient arms (26), the resilient arms (26) are configured to allow for the elastic distortion thereof as the mating contact (6) is brought into engagement with the socket (14), such that when the mating contact (6) is fully inserted, the resilient arms (26) will return toward an unstressed position to cooperate with the arcuate surface of the mating contact (6) to maintain the mating contact (6) in position.

8. A socket assembly as recited in claim 7 further characterized in that the resilient arms (26) extend circumferentially around the side wall (20).

## Patentansprüche

1. Buchsenanordnung, die aufweist: eine Buchse (14), die auf einem ersten Substrat (10) vorhanden ist, und einen bogenförmigen Gegenkontakt, der auf einem zweiten Substrat (2) vorhanden ist, wobei die Buchsenanordnung dadurch gekennzeichnet ist, daß:
die Buchse (14) Kontakthaltestellen (30) aufweist, die sich von einer Seitenwand (20) dieser erstrecken, wobei sich die Kontakthaltestellen (30) in eine Öffnung hinein erstrecken, die durch die Seitenwand (20) begrenzt wird, und wobei die Öffnung so dimensioniert ist, daß der bogenförmige Gegenkontakt (6) darin aufgenommen wird; wodurch, da das erste Substrat (10) und das zweite Substrat (2) miteinander in Eingriff kommen, der bogenförmige Gegenkontakt (6) in der Öffnung der Buchse (14) aufgenommen und darin durch die Kontakthaltestellen (30) festgehalten wird.

2. Buchsenanordnung nach Anspruch 1, außerdem dadurch gekennzeichnet, daß der bogenförmige Gegenkontakt (6) eine leitende Kugel ist.

3. Buchsenanordnung nach Anspruch 1 oder 2, außerdem dadurch gekennzeichnet, daß der Gegenkontakt (6) auf dem zweiten Substrat (2) oberflächenmontiert ist, und daß die Buchse (14) auf dem ersten Substrat (10) oberflächenmontiert ist.

4. Buchsenanordnung nach einem der Ansprüche 1 bis 3, außerdem dadurch gekennzeichnet, daß die Buchse (14) ein Schichtmaterial ist, wobei die Innenschicht des Schichtmaterials ein Material ist, das keine Zinnaffinität aufweist.

5. Buchsenanordnung nach einem der Ansprüche 1 bis 4, außerdem dadurch gekennzeichnet, daß das Schichtmaterial eine Innenfläche aus nichtrostendem Stahl aufweist.

6. Buchsenanordnung nach einem der Ansprüche 1 bis 5, außerdem dadurch gekennzeichnet, daß die Buchse (14) ein federhartes Metall ist.

7. Buchsenanordnung nach einem der Ansprüche 1 bis 6, außerdem dadurch gekennzeichnet, daß die Kontakthaltestellen (30) auf den elastischen Armen (26) bereitgestellt werden, daß die elastischen Arme (26) so ausgeführt sind, daß sie deren elastische Verformung gestatten, während der Gegenkontakt (6) mit der Buchse (14) in Eingriff gebracht wird, so daß, wenn der Gegenkontakt (6) vollständig eingesetzt ist, die elastischen Arme (26) in eine spannungsfreie Position zurückkehren werden, um mit der bogenförmigen Oberfläche des Gegenkontaktes (6) zusammenzuwirken, um den Gegenkontakt (6) in Position zu halten.

8. Buchsenanordnung nach Anspruch 7, außerdem dadurch gekennzeichnet, daß sich die elastischen Arme (26) peripher um die Seitenwand (20) herum erstrecken.

## Revendications

1. Assemblage de douille comprenant une douille (14), agencée sur un premier substrat (10), et un contact d'accouplement arqué, agencé sur un deuxième substrat (2), l'assemblage de douille étant caractérisé en ce que:
la douille (14) comporte des points de retenue du contact (30), s'étendant à partir d'une paroi latérale correspondante (20), les points de retenue du contact (30) s'étendant dans une ouverture définie par la paroi latérale (20), l'ouverture étant dimensionnée de sorte à recevoir le contact d'accouplement arqué (6); le contact d'accouplement arqué (6) étant ainsi reçu dans l'ouverture de la douille (14) et y étant retenu par les points de retenue du contact (30) lors de l'accouplement du premier substrat (10) et du deuxième substrat (2).

2. Assemblage de douille selon la revendication 1, caractérisé en outre en ce que le contact d'accouplement arqué (6) est une perle conductrice.

3. Assemblage de douille selon les revendications 1 ou 2, caractérisé en outre en ce que le contact d'accouplement (6) est monté en surface sur le deuxième substrat (2), la douille (14) étant montée en surface sur le premier substrat (10).

4. Assemblage de douille selon l'une quelconque des revendications 1 à 3, caractérisé en outre en ce que la douille (14) est composée d'un matériau stratifié, la couche interne du matériau stratifié étant composée d'un matériau ne présentant pas d'affinité pour l'étain.

5. Assemblage de douille selon l'une quelconque des revendications 1 à 4, caractérisé en outre en ce que le stratifié a une surface interne composée d'acier inoxydable.

6. Assemblage de douille selon l'une quelconque des revendications 1 à 5, caractérisé en outre en ce que la douille (14) est composée d'un métal trempé à ressorts.

7. Assemblage de douille selon l'une quelconque des revendications 1 à 6, caractérisé en outre en ce que les points de retenue du contact (30) sont agencés sur des bras élastiques (26), les bras élastiques (26) étant configurés de sorte à permettre leur déformation élastique lors de l'engagement du contact d'accouplement (6) dans la douille (14), de sorte qu'après l'insertion complète du contact d'accouplement (6), les bras élastiques (26) retournent vers une position détendue pour coopérer avec la surface arquée du contact d'accouplement (6), pour maintenir le contact d'accouplement (6) en position.

8. Assemblage de douille selon la revendication 7, caractérisé en outre en ce que les bras élastiques (26) s'étendent circonférentiellement autour de la paroi latérale (20).
